## Europäisches Patentamt
## European Patent Office
## Office européen des brevets

(11) Publication number: **0 195 716 B1**

## EUROPEAN PATENT SPECIFICATION

(45) Date of publication of patent specification: **25.03.92**

(51) Int. Cl.5: **H01L 23/52**, H01L 21/90

(21) Application number: **86400553.3**

(22) Date of filing: **14.03.86**

(54) **Thick bus metallization interconnect structure to reduce bus area.**

(30) Priority: **19.03.85 US 714132**

(43) Date of publication of application:
**24.09.86 Bulletin 86/39**

(45) Publication of the grant of the patent:
**25.03.92 Bulletin 92/13**

(84) Designated Contracting States:
**DE FR GB IT NL**

(56) References cited:
**WO-A-82/01102**
**US-A- 4 151 546**

**PATENT ABSTRACTS OF JAPAN, vol. 7, no.
94 (E-171)[1239], 20th April 1983; & JP - A - 58
18941**

**EXTENDED ABSTRACTS, vol. 84, no. 2, 1984,
pages 756-757, New Orleans, US; J.M. DE
BLASI et al.: "Etch barrier properties of
LPCVD tungsten"**

(73) Proprietor: **FAIRCHILD SEMICONDUCTOR
CORPORATION**
**10400 Ridgeview Court P.O. Box 1500
Cupertino, California 95014(US)**

(72) Inventor: **Hingarh, Henraj**
**12866 Pierce Road**
**Saratoga California 95070(US)**
Inventor: **Asuncion, Andres Dan**
**955 Bernardo Avenue**
**Sunnyvale California 94087(US)**
Inventor: **Thomas, Michael**
**20718 Garden Crest Court**
**Cupertino California 95014(US)**
Inventor: **Brown, Robert**
**1928 Cooley Avenue, E.**
**Palo Alto California 94303(US)**

(74) Representative: **Sparing Röhl Henseler Paten-
tanwälte European Patent Attorneys
Rethelstrasse 123
W-4000 Düsseldorf 1(DE)**

## Description

## BACKGROUND OF THE INVENTION

### 1. Field of the Invention

The subject invention relates generally to large-scale electronic circuit integration technology, and more particularly to an improved power busing scheme for large-scale integrated semiconductor chips.

### 2. Description of the Prior Art

The tremendous increase in the number of circuit devices such as transistors which can be fabricated on a given semiconductor substrate or "chip" had been a driving force behind the revolutionary advances in and availability of computers and other electronic products. Device density has been increased to the point where the electrical leads or buses used to supply power to the devices occupy an increasingly large share of the chip, reducing the area available for electronic devices.

Present bipolar VLSI chips typically employ an orthogonal bus scheme in which at least 30-40% of the chip area is occupied by the power buses. The power bus size is affected by two factors: (a) the electromigration limit, and (b) the maximum voltage drop tolerated along the bus by the circuit which depends on the technology used to fabricate the devices. With respect to the first factor, as current density increases, aluminum atoms in a conductor are swept into the negative charge stream. This phenomenon may result in deleterious localized heating or open circuits as the concentration of aluminum atoms is locally depleted. With respect to the second factor, the maximum voltage (IR) drop tolerable is that level at which erroneous circuit operation may occur. Erroneous operation may occur because IR drops in buses can slow charging of output capacitances, and can cause improper triggering or activation of devices. Inordinate power consumption and chip heating can result from partial activation of devices which should be in an "off" state.

The busing scheme must also cope with current surges, a particular problem in CMOS designs. The foregoing factors place severe constraints on a bus design, particularly on cross-sectional bus width, which affects current density and electromigration.

Power hungry bipolar technologies such as ECL and integrated injection logic cause aggravation or the above mentioned problems as device density on a single die increases. The higher current densities in more dense circuits cause increased problems with electromigration and IR voltage drop. To alleviate these problems, several things can be done. Among them is the option to decrease current density. One way to go that is to increase the cross sectional area of the bus. However, it is undesirable for the power buses to consume substantial portions of the chip area. If more area is consumed by buses, there is less useable chip area upon which to build devices.

There is yet another aspect of the problem not heretofore mentioned. As device size is decreased, the constraints on bus design become more acute. For example, a smaller transistor cannot charge a capacitance as rapidly. Since the leads (e.g. wires) being driven by these smaller VLSI transistors are just as long or longer than those used with physically larger transistors, the parasitic capacitance remains the same, and desired logic levels may take too long to be reached, resulting in erroneous operation or requiring slower clocking rates. Wider buses to handle increased current density have more parasitic capacitance because of greater area of one "plate" of the parasitic capacitor. Therefore wider buses aggravate the problem that was becoming worse by the on-going trend to reduce transistor size.

The response of the prior art to these design limits on device density has been to add additional layers of interconnecting metallization, i.e., third layer and fourth layer metallizations, each separated from the preceding layers by dielectric. Each layer of metallization is of a common thickness. Such schemes entail increased process complexity, requiring two to four additional masks and all the associated steps. Further, each additional mask causes an appreciable reduction in yield. Moreover, the full potential of extra layers of metallization cannot be always realized because of the larger vertical connection or "via" required to interconnect the first metallization layer to the third layer through the second and other subsequent layers. The larger vias occupy area which could otherwise be devoted to devices.

The document PATENT ABSTRACTS OF JAPAN Vol. 7 no. 94 (E-171)/1239/April 20 1983 discloses a process of forming a metallization structure for power buses and interconnects. At first, an aluminum layer is deposited and patterned to form the power buses. The whole surface of the wafer is thereafter covered by a second aluminum layer which is patterned to form the interconnects and a second portion of the power buses atop the first portion. Accordingly, the power bus pattern is etched twice, and in order to reduce consequences of misalignment, the second power bus pattern is designed larger than the first one so as to overlap the latter.

EP-0 161 981-A2 constitutes prior art under the provisions of Art. 54(3). It discloses a process for forming a metallization structure on a semiconductor substrate, the metallization structure being provided on several levels and the different patterns being in electrical contact at selected points but otherwise isolated from oneanother. A first layer is formed of a ternary aluminum alloy while the second layer is formed by a superposed structure consisting of a thin layer of an alloy rich in tantalum and a further layer of aluminum. Where the contacts between the two patterns are provided, the tantalum rich layer forms an alloy with both aluminum layers. Patterning is done by selective etching. First, the layer adjacent the substrate is patterned. Thereafter, an isolating layer is deposited and patterned to provide vias where the contacts are to be provided. The tantalum layer is formed and atop thereof, the second aluminum layer is deposited. The uppermost aluminum layer is patterned and the tantalum layer regions so exposed are removed by a selective etching process. Accordingly, tantalum remains only where the two aluminum layers must make contact and forms alloys with them.

Misaligning of the various masks used for the sequence of process steps is counteracted in that the vias in the isolating layer are made larger than the width of the layer pattern lines and columns on account of the consumed die surface.

It is the object of the present invention to provide an improvement of the process disclosed in PATENT ABSTRACTS OF JAPAN cited above so that overlap due to misalignment is avoided in order to reduced surface consumption while maintaining the necessary current capacity.

The solution according to the invention is defined in patent claim 1; the subclaims define preferred embodiments.

## BRIEF DESCRIPTION OF THE DRAWINGS

The invention will be better understood when considered in conjunction with the drawings of which:

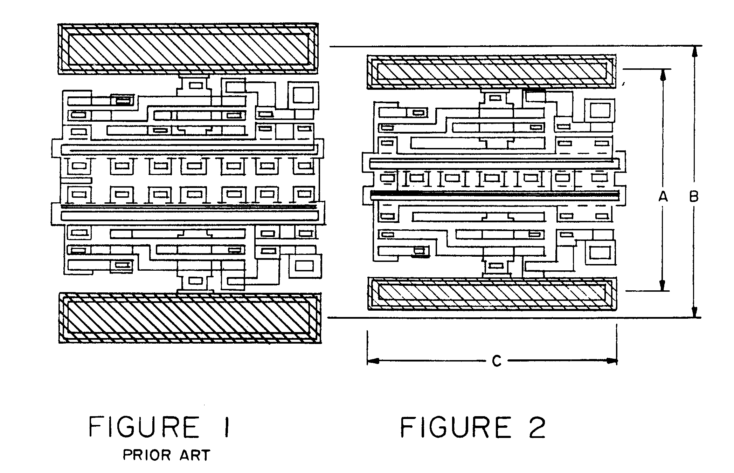

Figures 1 and 2 are typical views of a large-scale integrated circuit bus structure, Figure 2 illustrating the relative reduction in bus size resulting from application of the invention over the prior art represented by Figure 1;

Figure 3 is a top view or the first layer of the metallization structure according to a first embodiment of the invention;

Figure 4 is a sectional view of the first and second metal layers in an integrated circuit structure employing a double metallization structure on the second metallization layer of a chip and with interconnect lines of a single layer thickness on the second metal layer;

Figure 5 is a top view of a second embodiment of a metallization structure according to the invention;

Figure 6 is a sectional view of an integrated circuit employing the multiple layer sandwich metallization structure of an alternative embodiment of the invention on the first metallization layer of a two layer IC and using single layer thickness interconnect lines;

Figures 7-9 illustrate a process for fabrication of an exemplary, simplified, self aligned metallization structure according to the preferred embodiment of the invention;

Figure 10 illustrates a sectional view of a self aligned, extra thick integrated circuit metallization structure according to the preferred embodiment using two dissimilar conductive materials on the first metallization layer and using a double layer interconnect line;

Figure 11 illustrates a sectional view of a self aligned integrated circuit structure according to the preferred embodiment using two dissimilar conductive materials on the second metallization layer and using double layer interconnect lines.

## DETAILED DESCRIPTION OF THE PREFERRED EMBODIMENT

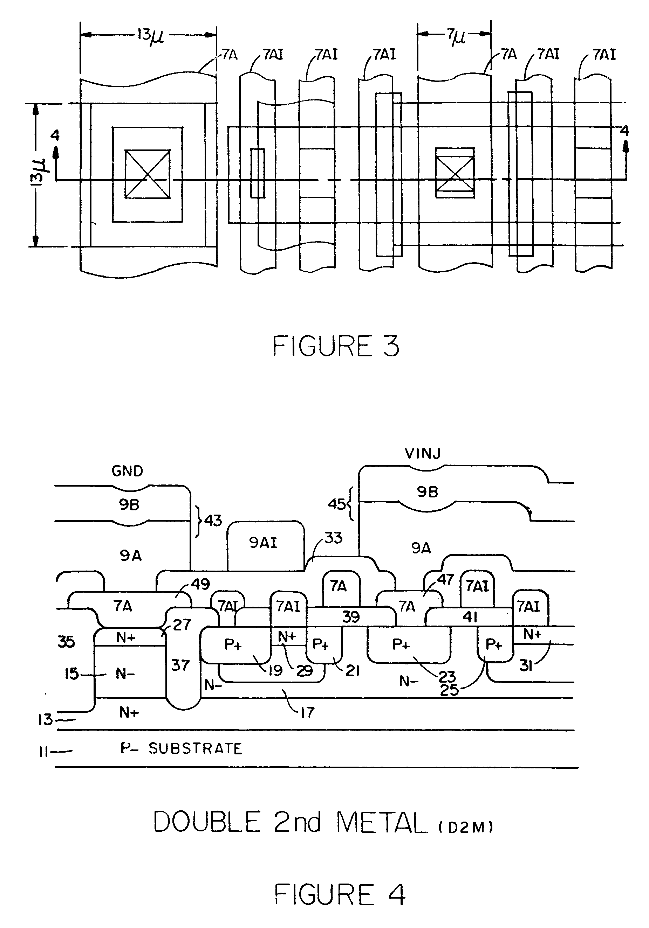

A first embodiment of the invention is illustrated in Figures 3 and 4. The cross-section of Figure 4A is taken at 4-4 of Figure 3 after the layers 9A and 9B have been added (Figure 3 does not show layers 9A and 9B for clarity purposes) and illustrates device layers on a substrate overlaid by a metallization structure consisting of a power bus 45 and ground bus 43 and interconnect lines 60. The device layers include a P- substrate 11, an N+ layer 13, N- epi layers 15, 17, P- base layer, P+ layers 19, 21, 23, 25 and N+ layers 27, 29, 31. These layers and device structures are meant to be illustrative only, and are not part of the invention.

The metallization structure includes a first metal layer including a layer 7A and first layer interconnects branches 7AI which are electrically connected to layer 7A. These layers 7A, 7AI are of the same thickness. This thickness can be conventional. The metallization structure further includes a second composite conductive layer comprised of layers 9A and 9B defining two power bus structures 43, 45, and a single layer thickness second layer interconnect 9AI. A dielectric layer 33 lies between the second layer interconnect 9AI and the first layer interconnect 7AI. Additional dielectric areas include areas designated 35, 37, 39, 41. All of the foregoing structures are formed by conventional methods which are well known to those skilled in the art. The layers 9A and 9B are formed in separate masking and etching steps, so proper alignment of these masks is important. Misalignment of layers 9A and 9B should not exceed the maximum mask alignment tolerance of the process.

The second layer ground and power bus structures 43, 45, because of their first and second strata 9A, 9B, provide for a thicker bus structure having a lesser width than bus structures of the prior art but having the same cross-sectional area as prior buses. This means buses 43 and 45 can carry the same amount of current as the wider buses of prior art structures without suffering from electromigration or IR drop problems, but they consume less surface area on the chip since they are vertically integrated into the device structure.

A metal layer comprising conductors 7A and 7AI is deposited to form the first metal layer interconnect pattern on the device. The 7AI conductor is in electrical contact with the 7A conductor and acts as an interconnect line to other devices. The 7A conductor is in electrical contact with the power bus to be defined above it in the second and third metal layers designated 9A and 9B. Following definition of the first metal layer, a layer 33 of silicon dioxide is deposited. Following deposit of the silicon dioxide layer 33, the second and third metal layers 9A and 9B are deposited in a single deposition sequence. The advantage of this is that a normal thickness of photoresist can be used on the 9A layer to define the bus main body and the interconnects. This normal thickness of photoresist will not degrade the resolution of the photolithography process as thicker photoresists would. Thicker photoresist is needed on thicker conductive layers that must be defined by etching, because the etching attacks the photoresist. Thus, its thickness must be large enough to last throughout the etch time during which the exposed material not covered by photoresist is etched. Thicker photoresist layers degrade resolution, and tend to force larger feature sizes. These problems do not exist in the embodiment of Figure 4A.

Thicker resist must be thick enough to withstand, at the edge of the wafer, the long etch times required by die in the middle of the wafer because of the uneven etch rates in plasma etching between die in the middle of the wafer and die at the edge of the wafer. Thicker resists however degrade the resolution of the photolithography process, so the interconnect lines 9AI must not be defined with an aspect ratio or feature size which is smaller than can be obtained with the resolution limits established by the thicker resist coatings. Those skilled in the art will appreciate that the resolution limits, resist coating thickness, feature sizes, and conductor layer thickness parameters depend upon the current density that the particular design must handle, the design rules and resolution capability of the particular photolithography system used.

As briefly mentioned above, the plasma etching process does not etch at a uniform rate across the surface of a wafer. Plasma etching usually etches at a faster rate on the periphery of the water than in the middle. Because the etching must continue until the etch is complete in these middle die, the etching also must continue on the outer die. This continued etching on the outer die attacks the structures underneath the second metal layer and can render the circuits unuseable on these outer die thereby decreasing yield. Another problem caused by the over etching at the periphery of the wafer is that the plasma etching process can become isotropic after the field is completely cleared of second layer metal. This can lead to undesirable undercutting and a loss in the useful cross section of the second layer metal patterns.

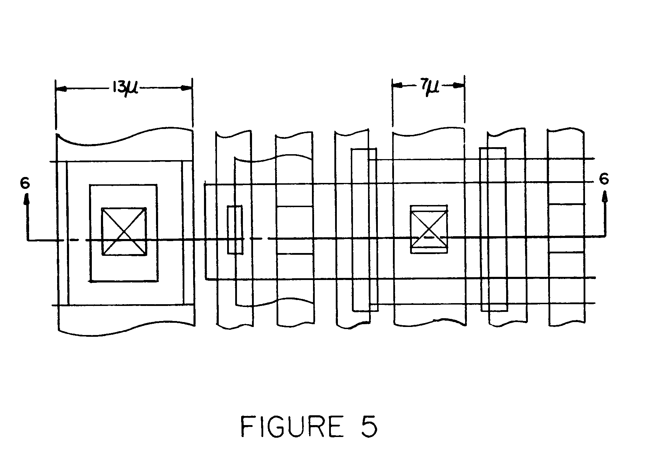

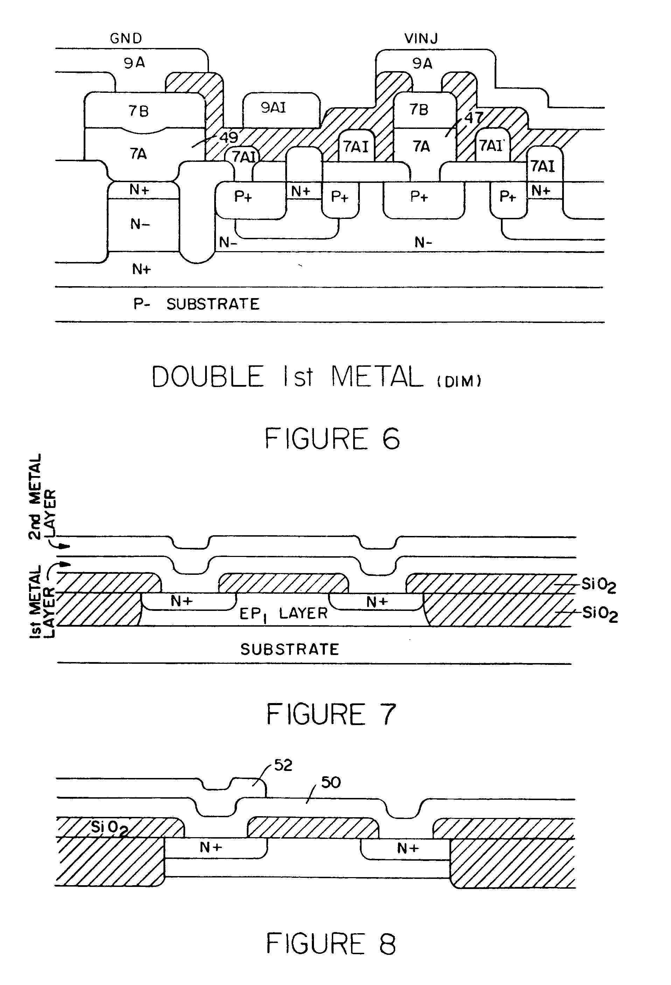

The second embodiment of Figures 5 and 6 utilizes the thicker bus conductor on the first layer of a dual conductive layer IC and utilizes single layer thick interconnects. The embodiment of Figures 5 and 6 uses the same semiconductor substrate structure as Figures 4 and 5.

A preferred process for forming self-aligned power bus structures having a different thickness than the surrounding digital interconnect lines will now be described. This process employs a dual conductor structure which yields two disimilar conductive layers in electrical contact with each other and in self-alignment such that only one mask need be used to define them.

The process is outlined as follows with respect to Figures 7-10. As shown in Figure 7, a dual conductor layered structure of two dissimilar conductor layers 50 and 52 is first deposited on a wafer at the contact mask stage. For example, the first metal layer 50 may be aluminum with a typical thickness of 500 nm (5,000 angstroms). Alternatively, the first layer 50 may be tungsten with a typical thickness of from 750 to 1000 nm (7,500 to 10,000 angstroms).

The second layer 52 must have, a substantially different etch rate than the first layer 50. For example, the first layer could be aluminum and the second layer could be tungsten or silicide. Conversely, the first and second layers could be in the reverse order. It is only necessary that the two conductive materials be such that two etching processes exist one of which etches only one of the materials and not the second material while the second etching process etches only the second material and not the first. The reason for this will become apparent from the discussion below.

Assuming that the first layer 50 is aluminum and that the second layer 52 is tungsten, photoresist is deposited and defined so as to protect the areas where the buses and interconnects are to be formed. Next a fluorine bearing plasma etch process is used to etch away all the tungsten layer 52 except those portions protected by the photoresist. Those skilled in the art will appreciate the type of photoresist to be used and the method of depositing, exposing, developing and dissolving the undeveloped resist to define an area of the layer 52 to be protected from the fluorine plasma. Those skilled in the art will appreciate that any other etching techniques may be used also if they attack only the second conductor layer 52 while not attacking the first layer metal 50. That is, the unwanted tungsten is etched away, exposing the underlying aluminum in the layer 50. The aluminum is not attacked by the fluorine plasma and therefore acts as an etch stop. The photoresist employed in masking for the fluorine etch is then removed. Figure 8 illustrates the wafer structure at this stage.

The wafer is then remasked after deposition of a photoresist to define the interconnects in the aluminum layer 50 if interconnects having only the thickness of the aluminum layer are desired. If dual thickness interconnects are desired, they would have been defined in the earlier photoresist deposit and definition steps to protect the areas in the layer 52 that are to form the second layer of the interconnect line. If single layer thickness interconnects are desired, then photoresist is deposited and developed using another mask so as to define only the interconnect lines 54 to be defined in the first layer conductor 50 connecting the power bus 56 to various nodes in the circuit. This mask does not have to be aligned with the mask registration marks for the mask used to define the power buses since the previously defined tungsten or silicide lines will serve as a mask to protect from the second etch those areas of aluminum or other conductor which are to form the first layer in the two layers of the extra thick bus structure. Next the aluminum not protected by either the top layer conductor 52 still remaining or the photoresist just deposited and defined is etched away with a chlorine bearing plasma. Because of the material selection for the second conductor layer, the second layer conductor 52 serves to mask the first layer conductor 50 from any etching since the second layer conductor 52 is impervious to the etch plasma used to etch the first layer conductor 50.

Thus a self aligned thick bus structure is obtained which can have a more narrow width than previously possible. Basically, the desired dimensions of the power bus and interconnects are determined by determining the current drawn in the application the structure is to be used in, and then determining the necessary cross sectional area after determining the maximum current density that the bus conductor can withstand without electromigration or IR drop problems. Once this cross sectional area is determined, and the maximum surface area over the substrate that can be used by the bus is determined, then the thickness of the bus can be determined.

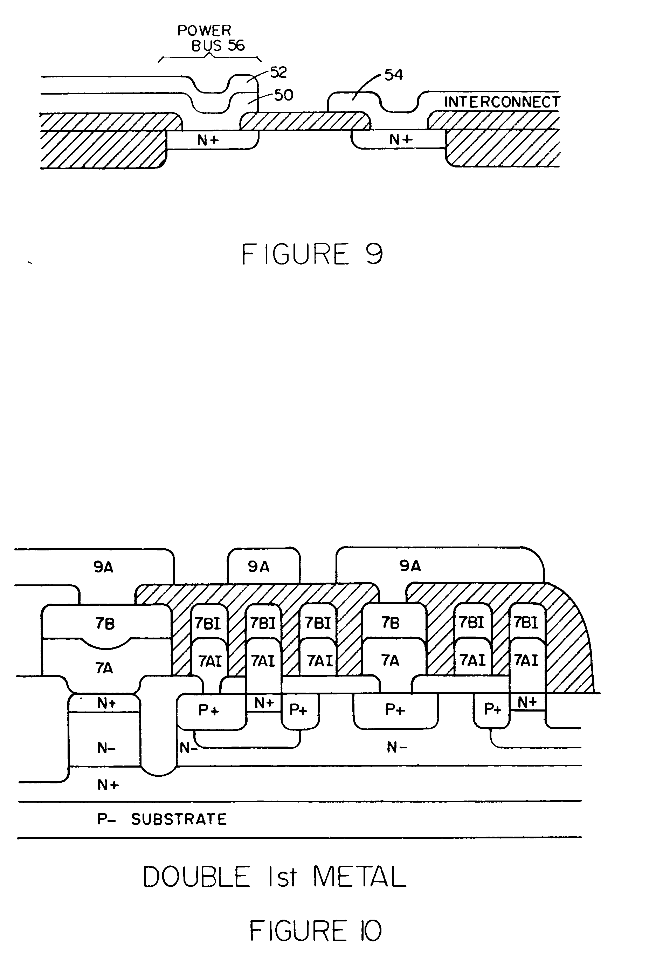

The self aligned structure after this first layer etch is shown in Figure 9. Other processing steps may then be carried out to complete the device. All of the above processing steps can be accomplished using conventional techniques to perform each step. Such techniques are well known in the art, and are described in, inter alia, "Integrated Circuit Fabrication Technology" by David J. Elliott, Library of Congress number TK 7874.E49 and "Semiconductor and Integrated Circuit Fabrication Techniques" by Peter Gise and Richard Blachard, Library of Congress number TK7871.85.F298 both of which are hereby incorporated by reference.

With this self-aligned double thick metal process, two alternatives are available (1) to define all of the interconnect and bus lines at the same thickness or (2) to have the interconnect lines defined in the first layer conductor only and completely isolated from the second level conductor of the bus lines with a thick dielectric in order to reduce capacitive coupling between the two metal layers. The first alternative - a self aligned, double thick first layer embodiment - is shown in Figure 10. In Figure 10, the power buses are denominated by first strata conductor 7A in the first conductor layer and second strata conductor 7B also of the first conductor layer, where both strata are in electrical contact with each other. The interconnect lines are designated by first strata conductor 7AI and second strata conductor 7BI also in electrical contact with other. The structure of Figure 10 can be formed by the self aligned process described with reference to Figures 7-9 by simultaneously defining both the buses and the interconnects with one mask at the second layer, i.e., the tungsten or silicide layer 52. Thereafter, the second layer 52 is used as the mask for the first layer 50.

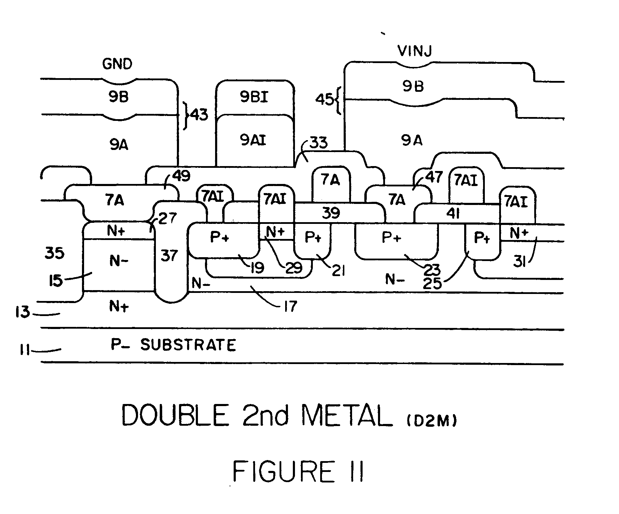

Figure 11 shows another self aligned embodiment with double thick second conductor layer buses, i.e., 9A and 9B, and double thick interconnects 9AI and 9BI. This structure may be made using the process defined in Figures 7-9.

It must be kept in mind that the relative resistivity of tungsten is around 10 micro-ohm-cm and that of aluminum alloys is around 3.2 micro-ohm-cm. Reports have shown that, for thicknesses above 450 nm (4,500 angstroms), tungsten resistance drops towards its theoretical value of 5.3 micro-ohm-cm. These considerations are relevant to the fraction of current carried by the dual layer conductor and the selection of the relative thicknesses of the respective metals employed.

The embodiments of Figures 10 and 11 have certain advantages which cause the inventors to presently consider them the preferred embodiments. First, the second conductor layer of the interconnects 7BI (or 9BI) can be designed to carry one-third of the current load. This reduces the current density in and the electromigration problem faced by aluminum first layer conductor 7AI (or 9AI) interconnects to the point where copper need not be put in the aluminum conductors to prevent electromigration. This renders the aluminum layer 7AI (or 9AI) easier to etch by eliminating undesirable compounds of copper which may form in the etching process. The embodiments of Figures 10 and 11 also require one less mask than that of the non-self-aligned embodiments and may provide faster switching speeds in some architectures. The embodiments of Figures 10 and 11 tend to minimize capacitance between the power bus and interconnect lines.

## Claims

1. A process for forming a metallization structure for power and interconnect buses in an integrated circuit comprising the steps of:
   - providing a semiconductor substrate (11) having circuit elements formed therein,
   - forming a first conductive layer (50) of a first predetermined thickness on said substrate, said first conductive layer being insulated from said substrate except where connections with said elements are desired,
   - forming a second conductive layer (52) of a second predetermined thickness of a different material to said first conductive layer and atop of said first conductive layer, said second and first conductive layer being in electrical contact,
   - masking portions of said second conductive layer where said power buses (56) are to be formed,
   - etching exposed surfaces of said second conductive layer while said first conductive layer acts as an etch stop,
   - masking portions of the exposed surface of said first conductive layer where interconnects (54) are to be formed, and
   - etching those portions of said first conductive layer where the latter is not protected by said masking or non-etched portions of said second conductive layer using an etchant that does not attack said second conductive layer, said metallization structure thereby defining said power buses with a thickness greater than the thickness of said interconnects.

2. The process of claim 1 further including the step of:
   - forming a third conductive layer interposed between said to-be-formed power bus and said circuit elements.

3. The process of claim 1 further including the step of:
   - forming a third conductive layer atop said to-be-formed power bus and in electrical contact therewith.

4. The process of claim 1 wherein said etching steps include plasma etching processes.

5. The process of claim 1 wherein said conductive layers consist of aluminum, tungsten, or silicide.

## Revendications

1. Procédé pour former une structure de métallisation pour des bus d'alimentation et d'interconnexion dans un circuit intégré comprenant les étapes consistant à :
   - fournir un substrat semi-conducteur (11) ayant des éléments de circuit formé dans ce dernier,
   - former une première couche conductrice (50) d'une première épaisseur prédéterminée sur ledit substrat, ladite première couche conductrice étant isolée dudit substrat à l'exception des endroits où les interconnexions avec lesdits éléments sont désirées,
   - former une seconde couche conductrice (52) d'une seconde épaisseur prédéterminée en un matériau différent de celui de ladite première couche conductrice et au-dessus de ladite première couche conductrice, lesdites première et seconde couches étant en contact électrique,
   - masquer des parties de ladite seconde couche conductrice où lesdits bus d'alimentation doivent être formés,
   - graver les surfaces exposées de ladite seconde couche conductrice, ladite première couche conductrice agissant comme arrêt de gravage,
   - masquer des parties de la surface exposée de ladite première couche conductrice où les interconnexions doivent être formés, et
   - graver ces parties de ladite première couche conductrice où cette dernière n'est pas protégée par ledit masquage ou des parties non gravées de ladite seconde couche conductrice en utilisant un agent de gravage qui n'attaque pas ladite seconde couche conductrice, ladite structure de métallisation définissant ainsi lesdits bus d'alimentation avec une épaisseur plus grande que l'épaisseur desdites interconnexions.

2. Procédé selon la revendication 1 comprenant, en outre, l'étape consistant à :
   - former une troisième couche conductrice interposée entre ledit bus d'alimentation devant être formé et lesdits éléments de circuit.

3. Procédé selon la revendication 1 comprenant, en outre, l'étape consistant à :
   - former une troisième couche conductrice au-dessus dudit bus d'alimentation devant être formé et en contact électrique avec celui-ci.

4. Procédé selon la revendication 1 dans lequel lesdites étapes de gravage comprennent des procédés de gravage au plasma.

5. Procédé selon la revendication 1 dans lequel lesdites couches conductrices sont en aluminium, en tungstène ou en siliciure.

**Patentansprüche**

1. Ein Verfahren für die Bildung einer Metallisierungsstruktur für Leistungs- und Verdrahtungsbusse in einer integrierten Schaltung, umfassend die Schritte:
   Bereitstellen eines Halbleitersubstrats (11) mit darin gebildeten Schaltkreiselementen,
   - Bilden einer ersten leitenden Schicht (50) einer ersten vorbestimmten Dicke auf dem Substrat, welche erste leitende Schicht von dem Substrat isoliert ist mit Ausnahme dort, wo Verbindungen mit den Elementen gewünscht sind,
   - Bilden einer zweiten leitenden Schicht (52) einer zweiten vorbestimmten Dicke aus einem Material, das abweicht von dem der ersten leitenden Schicht und auf diese aufgebracht wird, welche zweite und erste leitende Schicht in elektrischem Kontakt stehen,
   - Maskieren von Abschnitten der zweiten leitenden Schicht, wo die Leistungsbusse (56) zu bilden sind,
   - Ätzen freiliegender Oberflächen der zweiten leitenden Schicht, während die erste leitende Schicht als Ätzbarriere dient,
   - Maskieren von Abschnitten der freiliegenden Oberfläche der ersten leitfähigen Schicht, wo Verdrahtungen (54) zu bilden sind, und
   - Ätzen jener Abschnitte der ersten leitfähigen Schicht, wo die letztere nicht durch die Maskierung oder nicht-geätzte Abschnitte der zweiten leitenden Schicht geschützt ist, unter Verwendung eines Ätzmittels, das die zweite leitende Schicht nicht angreift, wodurch die Metallisierungsstruktur die Leistungsbusse mit einer Dicke ausbildet, die größer ist als die Dicke der Verdrahtungen.

2. Das Verfahren nach Anspruch 1, umfassend den Schritt:
   - Bilden einer dritten leitfähigen Schicht, eingebettet zwischen dem zu bildenden Leistungsbus und den Schaltkreiselementen.

3. Das Verfahren nach Anspruch 1, ferner umfassend den Schritt:
   - Bilden einer dritten leitfähigen Schicht über dem zu bildenden Leistungsbus und in elektrischem Kontakt mit diesem.

4. Das Verfahren nach Anspruch 1, bei dem die Ätzschritte Plasma-Ätzprozesse umfassen.

5. Das Verfahren nach Anspruch 1, bei dem die leitfähigen Schichten aus Aluminium, Wolfram oder Silicid bestehen.

FIGURE 2

FIGURE 1

PRIOR ART

FIGURE 3

DOUBLE 2nd METAL (D2M)

FIGURE 4

FIGURE 5

GND                                     VINJ

9A                                      9A

7B              9AI            7B    47

7A        49   7AI      7AI   7A    7AI     7AI

N+         7AI   N+   P+   P+        P+    N+

N−                              P+

N−        N−              N−

N+

P−  SUBSTRATE

## DOUBLE 1st METAL (DIM)

## FIGURE 6

2nd METAL LAYER

1st METAL LAYER

SiO₂

N+        EP₁ LAYER        N+

SiO₂

SUBSTRATE

## FIGURE 7

52        50

SiO₂

N+        N+

## FIGURE 8

11

POWER
BUS 56

52

50

54

INTERCONNECT

N+

N+

# FIGURE 9

9A

9A

9A

7B

7BI 7BI 7BI 7B 7BI 7BI

7A 7AI 7AI 7AI 7A 7AI 7AI

N+ P+ N+ P+ P+ P+ N+

N- N- N-

N+

P- SUBSTRATE

DOUBLE 1st METAL

# FIGURE 10

DOUBLE 2nd METAL (D2M)

FIGURE II